# EUROPEAN PATENT APPLICATION

(11) **EP 3 144 409 A1**
(43) Date of publication of application: **22.03.2017**
(21) Application number: 16189667.5
(22) Date of filing: 20.09.2016
(51) Int. Cl.: C23C 10/18, C23C 10/20, C23C 10/30, C23C 10/60, C23C 28/00

(54) **THERMAL BARRIER COATING SYSTEM AND PROCESSES FOR FORMING A THERMAL BARRIER COATING SYSTEM**

(30) Priority: 21.09.2015 US 201514859587
(71) Applicant: General Electric Company, Schenectady, NY 12345 (US)
(72) Inventor: ZHANG, Liming, Greenville, SC 29615 (US); THOMPSON, Christopher Edward, Greenville, SC 29615 (US); CONNOR, James Ryan, Greenville, SC 29615 (US); WARD, John D., Greenville, SC 29615 (US); DEPALMA, Michael Anthony, Greenville, SC 29615 (US)
(74) Representative: Pöpper, Evamaria

(57) **Abstract**

A process for forming a thermal barrier coating system (100) on a substrate (102) is disclosed including preparing a slurry including a donor powder, an activator powder, and a binder. The donor powder includes a metallic aluminum alloy having a melting temperature higher than aluminum, and the binder includes at least one organic polymer gel. The process further includes applying the slurry to the substrate (102), heating the slurry to form an aluminide bond coating (106) including an additive aluminide layer (108) and an aluminide interdiffusion zone (110) disposed between the substrate (102) and the additive aluminide layer (108), and applying a thermal barrier coating (104) to the aluminide bond coating (106). The thermal barrier coating (104) may be a dense vertically-cracked thermal barrier coating (104), and the substrate (102) may be a gas turbine component. Thermal barrier coating systems (100) formed by the process are also disclosed.

## Description

### FIELD OF THE INVENTION

The present invention is directed to a thermal barrier coating system and processes for forming a thermal barrier coating system. More particularly, the present invention is directed to a thermal barrier coating system and processes for forming a thermal barrier coating system incorporating an aluminide bond coating.

### BACKGROUND OF THE INVENTION

Gas turbines include components, such as buckets (blades), nozzles (vanes), combustors, shrouds, and other hot gas path components which are coated with a thermal barrier coating to protect the components from the extreme temperatures, chemical environments and physical conditions found within the gas turbines. A bond coating may be applied between the component and the thermal barrier coating, said bond coating increasing the bond strength of the thermal barrier coating to the component and offering additional protection. Such bond coatings may currently be applied by high-velocity oxygen fuel (HVOF) or vacuum plasma spray (VPS) techniques, which processes are expensive and further lead to elevated maintenance costs of the component.

### BRIEF DESCRIPTION OF THE INVENTION

In an exemplary embodiment, a process for forming a thermal barrier system coating on a substrate includes preparing a slurry including, by weight, about 35 to about 65% of a donor powder, about 1 to about 25% of an activator powder, and about 25 to about 60% of a binder. The donor powder includes a metallic aluminum alloy having a melting temperature higher than aluminum, and the binder includes at least one organic polymer gel. The process further includes applying the slurry to the substrate, heating the slurry to form an aluminide bond coating including an additive aluminide layer and an aluminide interdiffusion zone disposed between the substrate and the additive aluminide layer, and applying a thermal barrier coating to the aluminide bond coating.

In another exemplary embodiment, a process for forming a dense vertically-cracked thermal barrier coating system on a gas turbine component includes providing the gas turbine component having a substrate and preparing a slurry including a donor powder, an activator powder, and a binder. The donor powder includes a metallic aluminum alloy having a melting temperature higher than aluminum, and the binder includes at least one organic polymer gel. The process further includes applying the slurry directly to the substrate, heating the slurry to form an aluminide bond coating including an additive aluminide layer and an aluminide interdiffusion zone disposed between the substrate and the additive aluminide layer, and applying a dense vertically-cracked thermal barrier coating directly to the additive aluminide layer of the aluminide bond coating.

In another exemplary embodiment, a thermal barrier coating system on a substrate includes a thermal barrier coating and an aluminide bond coating disposed between the substrate and the thermal barrier coating, the aluminide bond coating including an additive aluminide layer and an aluminide interdiffusion zone disposed between the substrate and the additive aluminide layer.

Other features and advantages of the present invention will be apparent from the following more detailed description of the preferred embodiment, taken in conjunction with the accompanying drawings, which illustrate, by way of example, the principles of the invention.

### BRIEF DESCRIPTION OF THE DRAWINGS

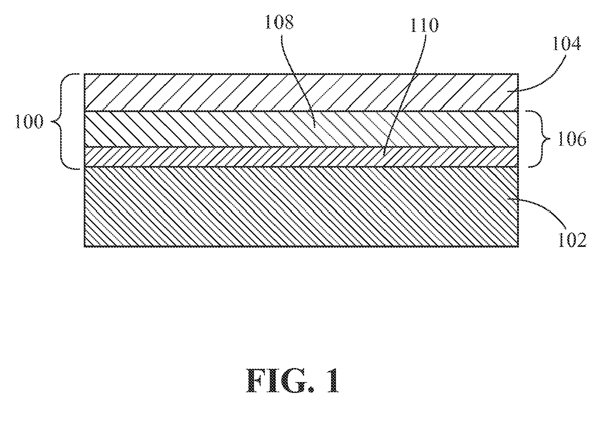

FIG. 1 is a sectional view of a thermal barrier coating system, according to an embodiment of the present disclosure.

Wherever possible, the same reference numbers will be used throughout the drawings to represent the same parts.

### DETAILED DESCRIPTION OF THE INVENTION

Provided are exemplary thermal barrier coating systems and methods for forming a thermal barrier coating system. Embodiments of the present disclosure, in comparison to methods not utilizing one or more features disclosed herein, increase efficiency, reduce application costs, reduce maintenance costs, or a combination thereof.

Referring to FIG. 1, in one embodiment, a thermal barrier coating system 100 on a substrate 102 includes a thermal barrier coating 104 and an aluminide bond coating 106 disposed between the substrate 102 and the thermal barrier coating 104, the aluminide bond coating 106 including an additive aluminide layer 108 and an aluminide interdiffusion zone 110 disposed between the substrate 102 and the additive aluminide layer 108. In a further embodiment, the aluminide bond coating 106 is an outward-type coating.

In one embodiment, the aluminide bond coating 106 directly contacts the substrate 102, the thermal barrier coating 104 directly contacts the additive aluminide layer 108 of the aluminide bond coating 106, and the thermal barrier coating system 100 is free from any MCrAlY bond coating. As used herein, "free from any MCrAlY bond coating" indicates that a layer of a MCrAlY bond coating is not incorporated into the thermal barrier coating system 100 on the substrate 102, and further, that the substrate 102 does not include a layer of a MCrAlY bond coating contacting the thermal barrier coating system 100.

In one embodiment, the substrate 102 is a gas turbine component. The gas turbine component may be any suitable gas turbine component, including, but not limited to, a hot gas path component, a bucket (blade), a nozzle (vane), a shroud, a combustor, or a combination thereof.

In one embodiment, the substrate 102 includes an iron-based superalloy, a nickel-based superalloy, a cobalt-based superalloy, or a combination thereof.

The thermal barrier coating 104 may be any suitable thermal barrier coating 104, including, but not limited to, yttria-stabilized zirconia. In one embodiment, the thermal barrier coating 104 is a dense vertically-cracked thermal barrier coating 104.

In one embodiment, the additive aluminide layer 108 includes environmentally-resistant intermetallic phases such as MAl, where M is iron, nickel or cobalt, depending on the substrate 102 material. The chemistry of the additive aluminide layer 108 may be modified by the addition of elements, such as chromium, silicon, platinum, rhodium, hafnium, yttrium, zirconium, or a combination thereof. Such modification may modify the environmental and physical properties of the additive aluminide layer 108. In one embodiment, the additive aluminide layer 108 includes a thickness of up to about 50 µm, alternatively up to about 75 µm, alternatively up to about 100 µm, alternatively between about 25 µm to about 75 µm, alternatively between about 50 µm to about 100 µm.

In one embodiment, the aluminide interdiffusion zone 110 includes a thickness of up to about 25 µm, alternatively up to about 50 µm, alternatively up to about 75 µm, alternatively between about 10 µm to about 40 µm, alternatively between about 20 µm to about 50 µm, alternatively between about 30 µm to about 60 µm. The aluminide interdiffusion zone 110 may include various intermetallic and metastable phases that form during the coating of the substrate 102 with the thermal barrier coating system 100. Without being bound by theory, it is believed that the various intermetallic and metastable phases form due to diffusional gradients and changes in elemental solubility in the local region of the substrate 102. The various intermetallic and metastable phases are distributed in a matrix of the substrate 102 material.

In one embodiment, a process for forming a thermal barrier coating system 100 on a substrate 102 includes preparing a slurry including a donor powder, an activator powder, and a binder, the donor powder including a metallic aluminum alloy having a melting temperature higher than aluminum, and the binder including at least one organic polymer gel. The slurry is applied to the substrate and heated to form the aluminide bond coating 106. The thermal barrier coating 104 is applied to the aluminide bond coating 106. An aluminide interdiffusion zone 110 forms between the substrate 102 and the additive aluminide layer 108 of the aluminide bond coating 106. In a further embodiment, the slurry is applied directly to the substrate 102, the thermal barrier coating 104 is applied directly to the additive aluminide layer 108 of the aluminide bond coating 106, and the thermal barrier coating system 100 is formed free from any MCrAlY bond coating.

The slurry may be heated on the substrate to a temperature within a range of about 815 °C to about 1150 °C. In one embodiment, following application of the slurry to the substrate 102, the substrate 102 is placed immediately in a coating chamber to perform the diffusion process. The coating chamber is evacuated, and may be backfilled with an inert or reducing atmosphere (such as argon or hydrogen, respectively). The temperature within the coating chamber is raised to a temperature sufficient to burn off the binder (e.g. about 150 °C to about 200 °C), with further heating being performed to attain the desired diffusion temperature, during which time the activator is volatized, the aluminum halide is formed, and aluminum is deposited on the substrate 102. The substrate 102 may be maintained at the diffusion temperature for a duration of about 1 to about 8 hours, depending on the final thickness desired for the additive aluminide layer 108 and the aluminide interdiffusion zone 110. Heating the slurry may form a residue. The residue may be removed by any suitable technique, including, but not limited to, directing forced gas flow at the aluminide bond coating 106, grit blasting the aluminide bond coating 106, or a combination thereof.

In one embodiment, the slurry includes, by weight, about 35 to about 65% of the donor powder, about 1 to about 25% of the activator powder, and about 25 to about 60% of the binder. In another embodiment, the slurry coating includes a non-uniform thickness with a minimum thickness of about 0.25 mm and a maximum thickness of about 6 mm or more, and the aluminide bond coating 106 has a thickness which varies by about 0.01 mm or less, and is therefore essentially independent of the thickness of the slurry coating. The slurry coating may include a maximum thickness of about 25 mm.

The donor powder may include a metallic aluminum alloy having a melting temperature higher than aluminum (melting point of about 660 °C). In one embodiment, the donor powder includes metallic aluminum alloyed with chromium, iron, another aluminum alloying agent, or a combination thereof, provided that the alloying agent does not deposit during the diffusion aluminiding process, but instead serves as an inert carrier for the aluminum of the donor material. In a further embodiment, the donor powder includes a chromium-aluminum alloy such as, but not limited to, by weight, 44% aluminum, balance chromium and incidental impurities. In another embodiment, the donor powder has a particle size of up to 100 mesh (149 µm), alternatively up to -200 mesh (74 µm). Without being bound by theory, it is believed that the donor powder being a fine powder reduces the likelihood that the donor powder will be lodged or entrapped within the substrate 102.

The activator powder may include any suitable material, including, but not limited to, ammonium chloride, ammonium fluoride, ammonium bromide, another halide activator or combinations thereof. Suitable materials for the activator powder react with aluminum in the donor material to form a volatile aluminum halide, such as, but not limited to, AlCl₃ or AlF₃, which reacts at the substrate 102 to deposit aluminum, which diffuses into the substrate 102, forming the aluminide bond coating 106 having the additive aluminide layer 108 and the aluminide interdiffusion zone 110.

The binder may include at least one organic polymer gel. Suitable binders include, but are not limited to, a polymeric gel available under the name Vitta Braz-Binder Gel from the Vitta Corporation, and low molecular weight polyols such as polyvinyl alcohol. In one embodiment, the binder further includes a cure catalyst, and accelerant, or both, such as, but not limited to, sodium hypophosphite.

In one embodiment, the slurry is free of inert fillers and inorganic binders. The absence of inert fillers and inorganic binders prevents such materials from sintering and becoming entrapped in the substrate 102.

The thermal barrier coating may be applied by any suitable technique, including, but not limited to, air plasma spraying, low pressure plasma spraying, HVOF, electron beam physical vapor deposition, or a combination thereof.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

Various aspects and embodiments of the present invention are defined by the following clauses:
1. A process for forming a thermal barrier coating system on a substrate, the process comprising:
   preparing a slurry including, by weight, about 35 to about 65% of a donor powder, about 1 to about 25% of an activator powder, and about 25 to about 60% of a binder, the donor powder including a metallic aluminum alloy having a melting temperature higher than aluminum, and the binder including at least one organic polymer gel;
   applying the slurry to the substrate;
   heating the slurry to form an aluminide bond coating including an additive aluminide layer and an aluminide interdiffusion zone disposed between the substrate and the additive aluminide layer; and
   applying a thermal barrier coating to the aluminide bond coating.
2. The process of clause 1, wherein the slurry is applied directly to the substrate, the thermal barrier coating is applied directly to the additive aluminide layer of the aluminide bond coating, and the thermal barrier coating system is formed free from any MCrAlY bond coating.
3. The process of clause 1, wherein the donor powder includes a chromium-aluminum alloy.
4. The process of clause 1, wherein the donor powder has a particle size of up to 100 mesh.
5. The process of clause 1, wherein the activator powder is selected from the group consisting of ammonium chloride, ammonium fluoride, ammonium bromide, and combinations thereof.
6. The process of clause 1, wherein applying the slurry coating includes applying the slurry coating with a maximum thickness of about 25 mm.
7. The process of clause 1, wherein the slurry is heated on the substrate to a temperature within a range of about 815 °C to about 1150 °C.
8. The process of clause 1, wherein forming the aluminide bond coating includes forming the aluminide bond coating as an outward-type coating.
9. The process of clause 1, wherein the substrate is a gas turbine component.
10. The process of clause 9, wherein the gas turbine component is selected from the group consisting of a bucket, a nozzle, a shroud, a combustor, a hot gas path component, and combinations thereof.
11. The process of clause 1, wherein the substrate includes a nickel-based superalloy.
12. The process of clause 1, wherein heating the slurry forms a residue which is removed by a technique selected from the group consisting of directing forced gas flow at the aluminide bond coating, grit blasting the aluminide bond coating, and combinations thereof.
13. The process of clause 1, wherein applying the slurry to substrate forms a slurry coating having a non-uniform thickness with a minimum thickness of about 0.25 mm and a maximum thickness of about 6 mm or more, and the aluminide bond coating has a thickness which varies by about 0.01 mm or less and is therefore essentially independent of the thickness of the slurry coating.
14. The process of clause 1, wherein applying the thermal barrier coating includes applying a dense vertically-cracked thermal barrier coating.
15. A process for forming a dense vertically-cracked thermal barrier coating system on a gas turbine component, the process comprising:
   providing the gas turbine component having a substrate;
   preparing a slurry including a donor powder, an activator powder, and a binder, the donor powder including a metallic aluminum alloy having a melting temperature higher than aluminum, and the binder including at least one organic polymer gel;
   applying the slurry directly to the substrate;
   heating the slurry to form an aluminide bond coating including an additive aluminide layer and an aluminide interdiffusion zone disposed between the substrate and the additive aluminide layer; and
   applying a dense vertically-cracked thermal barrier coating directly to the additive aluminide layer of the aluminide bond coating.
16. A thermal barrier coating system on a substrate, comprising:
   a thermal barrier coating; and
   an aluminide bond coating disposed between the substrate and the thermal barrier coating, the aluminide bond coating including an additive aluminide layer and an aluminide interdiffusion zone disposed between the substrate and the additive aluminide layer.
17. The thermal barrier coating system of clause 16, wherein the aluminide bond coating directly contacts the substrate, the thermal barrier coating directly contacts the additive aluminide layer of the aluminide bond coating, and the thermal barrier coating system is free from any MCrAlY bond coating.
18. The thermal barrier coating system of clause 16, wherein the aluminide bond coating is an outward-type coating.
19. The thermal barrier coating system of clause 16, wherein the substrate is a gas turbine component selected from the group consisting of a bucket, a nozzle, a shroud, a combustor, a hot gas path component, and combinations thereof.
20. The thermal barrier coating system of clause 16, wherein the substrate includes a nickel-based superalloy.

## Claims

1. A process for forming a thermal barrier coating system (100) on a substrate (102), the process comprising:
preparing a slurry including, by weight, 35 to 65% of a donor powder, 1 to 25% of an activator powder, and 25 to 60% of a binder, the donor powder including a metallic aluminum alloy having a melting temperature higher than aluminum,
and the binder including at least one organic polymer gel;
applying the slurry to the substrate (102);
heating the slurry to form an aluminide bond coating (106) including an additive aluminide layer (108) and an aluminide interdiffusion zone (110) disposed between the substrate (102) and the additive aluminide layer (108); and
applying a thermal barrier coating (104) to the aluminide bond coating (106).

2. The process of claim 1, wherein the slurry is applied directly to the substrate (102), the thermal barrier coating (104) is applied directly to the additive aluminide layer (108) of the aluminide bond coating (106), and the thermal barrier coating system (100) is formed free from any MCrAlY bond coating.

3. The process of claim 1, wherein the donor powder includes a chromium-aluminum alloy.

4. The process of claim 1, wherein the donor powder has a particle size of up to 0.15 mm (100 mesh).

5. The process of claim 1, wherein the activator powder is selected from the group consisting of ammonium chloride, ammonium fluoride, ammonium bromide, and combinations thereof.

6. The process of claim 1, wherein the slurry is heated on the substrate (102) to a temperature within a range of 815 °C to 1150 °C.

7. The process of claim 1, wherein forming the aluminide bond coating (106) includes forming the aluminide bond coating (106) as an outward-type coating.

8. The process of claim 1, wherein the substrate (102) is a gas turbine component.

9. The process of claim 1, wherein the substrate (102) includes a nickel-based superalloy.

10. The process of claim 1, wherein applying the thermal barrier coating (104) includes applying a dense vertically-cracked thermal barrier coating (104).

11. A process for forming a dense vertically-cracked thermal barrier coating system (100) on a gas turbine component, the process comprising:
providing the gas turbine component having a substrate (102);
preparing a slurry including a donor powder, an activator powder, and a binder, the donor powder including a metallic aluminum alloy having a melting temperature higher than aluminum, and the binder including at least one organic polymer gel;
applying the slurry directly to the substrate (102);
heating the slurry to form an aluminide bond coating (106) including an additive aluminide layer (108) and an aluminide interdiffusion zone (110) disposed between the substrate (102) and the additive aluminide layer (108); and
applying a dense vertically-cracked thermal barrier coating (104) directly to the additive aluminide layer (108) of the aluminide bond coating (106).

12. A thermal barrier coating system (100) on a substrate (1012), comprising:
a thermal barrier coating (104); and
an aluminide bond coating (106) disposed between the substrate (102) and the thermal barrier coating (104), the aluminide bond coating (106) including an additive aluminide layer (108) and an aluminide interdiffusion zone (110) disposed between the substrate (102) and the additive aluminide layer (108).

13. The thermal barrier coating system (100) of claim 12, wherein the aluminide bond coating (106) directly contacts the substrate (102), the thermal barrier coating (104) directly contacts the additive aluminide layer (108) of the aluminide bond coating (106), and the thermal barrier coating system (100) is free from any MCrAlY bond coating.

14. The thermal barrier coating system (100) of claim 12, wherein the substrate (102) is a gas turbine component selected from the group consisting of a bucket, a nozzle, a shroud, a combustor, a hot gas path component, and combinations thereof.

15. The thermal barrier coating system (100) of claim 12, wherein the aluminide bond coating (106) is an outward-type coating.
